# EUROPÄISCHE PATENTSCHRIFT

(11) **EP 2 964 005 B1**
(45) Veröffentlichungstag und Bekanntmachung des Hinweises auf die Patenterteilung: **07.12.2022**
(21) Anmeldenummer: 15173126.2
(22) Anmeldetag: 22.06.2015
(51) Int. Cl.: H05K 7/14

(54) **BUSVERBINDER-SYSTEM FÜR ELEKTRISCHE BETRIEBSMITTEL**
BUS CONNECTOR SYSTEM FOR ELECTRICAL INSTALLATION
SYSTEME DE CONNECTEUR DE BUS POUR MOYEN DE FONCTIONNEMENT ELECTRIQUE

(30) Priorität: 03.07.2014 DE 102014212969
(43) Veröffentlichungstag der Anmeldung: 06.01.2016
(73) Patentinhaber: Bender GmbH & Co. KG, 35305 Grünberg (DE)
(72) Erfinder: Kalkreuter, Ulrich, 35315 Homberg Ohm (DE); Meß, Helmut, 36320 Kirtorf (DE); Müller, Gerhard, 35305 Grünberg (DE)
(74) Vertreter: advotec.

(56) Entgegenhaltungen:
- DE-A1-102012 213 258
- JP-A- H1 195 807
- US-A- 4 790 762

## Beschreibung

Die Erfindung betrifft ein Busverbinder-System mit Busleiterplatten zur Herstellung einer elektrischen Verbindung zwischen elektrischen Betriebsmitteln.

Im Hinblick auf die Automatisierung und insbesondere die Überwachung elektrischer Anlagen gewinnt die Vernetzung der elektrischen Betriebsmittel zunehmend an Bedeutung. Eine der Hauptaufgaben besteht darin, einen zuverlässigen Informationsaustausch zwischen kommunikationsfähigen und in verstärktem Maße modular aufgebauten Überwachungs- und Messeinrichtungen zu gewährleisten. Neben der Spezifikation und Anwendung von Übertragungsprotokollen spielt dabei auch die physische Ausgestaltung der Datenübertragung eine wesentliche Rolle für die fehlerfreie Kommunikation zwischen den Geräten und Systemen. Insbesondere die bei einer Funktionserweiterung der elektrischen Anlage erforderliche schnelle und kostengünstige Herstellung einer elektrischen und mechanischen Verbindung zwischen Geräten stellt oftmals eine Schwierigkeit dar.

So ist beispielsweise aus dem Stand der Technik das 16-polige Tragschienen-Busverbinder-System HBUS der Firma Phoenix Contact (www.phoenixcontact.com) bekannt. Das Busverbinder-System HBUS beruht auf einem Tragschienen-Busverbinder mit entsprechender Gehäusebreite, der in eine Montageschiene (DIN-C-Schiene) eingesetzt und mit dieser verrastet wird. Dabei werden die Tragschienen-Busverbinder durch seitliches zusammenschieben über 16-polige Stecker- und Buchsenleisten miteinander elektrisch kontaktiert. Die Gerätegehäuse können dann auf die DIN-C-Schiene und somit gleichzeitig auf die Tragschienen-Busverbinder aufgeschnappt werden. Durch eine 18-polige Steckerleiste, die sich auf einer Leiterplatte in dem jeweiligen Gerätegehäuse befindet, und eine 18-polige Buchsenleiste auf dem Tragschienen-Busverbinder wird dabei der elektrische Kontakt zur Geräteelektronik hergestellt.

Ein für ein derartiges Busverbinder-System konzipiertes Elektronikgehäuse mit auf einer Montageschiene aufrastbarem Gehäuse-Sockelteil und zusammensteckbaren, verschiebbar auf der Montageschiene verrastbaren Busverbindern ist in der Offenlegungsschrift DE 20 2006 006 615 U1 offenbart.

Weiterhin ist aus dem Stand der Technik ein Bussystem der Firma E. Dold & Söhne KG unter der Bezeichnung "In-Rail-Bus - Bussystem in der Hutschiene" bekannt. Bei diesem System wird ein Trägerprofil aus Kunststoff mit vormontierter Busleiterplatte in eine DIN-C-Schiene eingelegt. Auf der Busleiterplatte sind parallel verlaufende Leiterbahnen aufgebracht, die bei Aufschnappen der Gerätegehäuse auf die Montageschiene über Kontaktfederblöcke, die auf den Leiterplatten der Geräte verbaut sind, kontaktiert werden.

Eine ähnliche Anordnung ist in der Offenlegungsschrift DE 10 2006 031 129 A1 beschrieben. Das dort offenbarte Gerätesystem weist auf einer Tragschiene montierte Gerätemodule auf, die über eine in der Tragschiene angeordnete Busleitung miteinander verbunden sind. Die Busleitung besitzt die Form einer langgestreckten Leiterplatte und ist mit aufschnappbaren Trägerelementen in der Tragschiene befestigt.

Alle vorgenannten Busverbinder-Systeme beruhen darauf, dass sie nur in Verbindung mit der Montage in einer DIN-C-Schiene (Hutschiene als Montageschiene/Tragschiene) funktionsfähig sind. Dabei muss zunächst die Busleiterplatte oder der Busverbinder in der Tragschiene mit geeigneten Haltemitteln positioniert werden, bevor das elektrische Gerät durch weitere Befestigungsmittel auf der Montageschiene angebracht werden kann. Die zwingend erforderliche Verwendung einer Montageschiene kann sich dabei im Hinblick auf den Montageaufwand als Nachteil erweisen. Die Offenlegungsschriften DE 10 2012 213258 A1, US 4 790 762 A und JP H11 95807 A offenbaren jeweils ein Busverbinder-System entsprechend dem Oberbegriff der Ansprüche 1 und 3.

Der vorliegenden Erfindung liegt somit die Aufgabe zu Grunde, ein Busverbinder-System für elektrische Betriebsmittel zu konzipieren, das in einfacher und kostengünstiger Weise sowohl eine flexible elektrische Kontaktierung als auch eine erweiterbare mechanische Verbindung verwirklicht.

Diese Aufgabe wird durch die Merkmale des Anspruchs 1 und in einer alternativen Lösung durch die Merkmale des Anspruchs 3 gelöst.

Der Grundgedanke der vorliegenden Erfindung beruht in vorteilhafter Weise darauf, dass die Busleiterplatte unmittelbar mit dem Gehäuse des elektrischen Betriebsmittels verbunden ist. Zur Herstellung der elektrischen Kontaktierung zwischen den Betriebsmitteln ist eine Tragschiene nicht erforderlich. Die erfindungsgemäße, direkte Befestigung der Busleiterplatte an einer Außenseite des Betriebsmittelgehäuses ohne Verwendung einer Tragschiene erlaubt somit den Einsatz kostengünstiger Leiterplatten in der Funktion als Busleiterplatte.

Die Busleiterplatte ist so dimensioniert, dass mit verbundenem Betriebsmittelgehäuse die Anbringung an einer DIN-C-Schiene möglich ist. Zugleich kann die Busleiterplatte im Rahmen des durch die DIN-C-Schiene zur Verfügung stehenden Bauraumes beliebig gestaltet werden, sie kann z.B. hinsichtlich der Anordnung und Anzahl der elektrischen Kontakte individuell an das elektrische Betriebsmittel angepasst werden. Da die Herstellung der elektrischen Verbindung zwischen den elektrischen Betriebsmitteln nicht an die Verwendung einer Tragschiene gebunden ist, besteht die Möglichkeit, das Gehäuse mit daran befestigter Busleiterplatte anstatt auf einer DIN-C-Schiene auf einer beliebigen Montageplatte zu installieren.

Die Busleiterplatten weisen vorzugsweise eine rechteckförmige Grundfläche auf, deren Abmessungen an DIN-Einbaugehäuse mit 45 mm-Normausschnitt angepasst werden können, im Grunde aber frei wählbar sind. Durch Zusammenstecken der Busleiterplatten entsteht eine langgestreckte Busanordnung in Form einer mechanischen Querverbindung für die seitlich nebeneinander angeordneten Gehäuse der elektrischen Betriebsmittel.

Die Busleiterplatte ist an einer Gehäusewand des Gehäuses mit einem Haltebügel befestigt, der als eigenständiges Bauelement ausgebildet ist. Im Gegensatz zu der integrierten Bauweise des unten beschriebenen Schnappelements stellt der Haltebügel zwar ein weiteres Einzelteil dar, kann aber dadurch optimal an die Einzelfunktion der Befestigung der Busleiterplatte angepasst werden. Dabei weist der Haltebügel ein oder mehrere Stege auf, die die Busleiterplatte überspannen.

Der Haltebügel weist Haken auf, die in Öffnungen der Gehäusewand eingreifen und durch seitliches Verschieben und Verrasten gegen Lösen gesichert sind. Um den Haltebügel an der Gehäusewand zu befestigen, ist dieser in einer bevorzugten Ausführung zu beiden Seiten des/der brückenförmigen Stege(s) mit Haken versehen, die in schlitzförmige Öffnungen des Gehäuses einsteckbar und verriegelbar sind.

Weiterhin weist die Busleiterplatte in der bevorzugten Ausführung eine Außenkontur mit Ausnehmungen auf, in die der Haltebügel eingreift.

Die (Außen-)Kontur der Busleiterplatte ist in der bevorzugten Ausführung an den in Bus-Längsausdehnung weisenden Kanten durch Ausnehmungen oder mit Sprüngen so geformt, dass der Haltebügel gegen seitliches Verschieben auf der Busleiterplatte gesichert ist und damit die Gehäusewand relativ zur Busleiterplatte fixiert.

Alternativ ist die Busleiterplatte mit einem Schnappelement an einer Gehäusewand des Gehäuses befestigt. Die Schnappverbindung als kraftformschlüssige Verbindung (Klips-System) reduziert den Montageaufwand gegenüber anderen Verbindungstechniken wie beispielsweise Schraubverbindungen und ist im Gegensatz zu Schweiß- oder Klebeverfahren leicht lösbar. Die Busleiterplatte kann an einer beliebigen Gehäusewand des Gehäuses befestigt sein, sofern sich die Gehäusewand auf Grund ihrer Beschaffenheit zur Anbringung eignet.

Das Schnappelement ist als integriertes Bauelement an der Gehäusewand ausgebildet. Das Schnappelement ist somit ein fester Bestandteil der Gehäusewand. Im Sinne einer kostengünstigen und montagefreundlichen Lösung verringert diese integrierte Bauweise die Anzahl der Einzelteile des Busverbinder-Systems. Die Busleiterplatte wird in einfacher Weise in die Schnappelemente an die Gehäusewand eingeklipst. Die Busleiterplatte weist dabei eine Außenkontour mit Ausnehmungen auf, in die das Schnappelement eingreift. Die (Außen-)Kontur der Busleiterplatte ist dabei an den in Bus-Längsausdehnung weisenden Kanten durch Ausnehmungen oder mit Sprüngen so geformt, dass das Schnappelemente gegen seitliches Verschieben auf der Busleiterplatte gesichert ist und damit die Gehäusewand relativ zur Busleiterplatte fixiert.

Die Schnappelemente sind dabei bevorzugt als Schnapphaken ausgebildet. Der Schnapphaken als Biegeelement mit hoher Verformungsfestigkeit gewährleistet bei der Verrastung mit der Busleiterplatte eine zuverlässige mechanische Verbindung.

In einer zweckmäßigen Ausgestaltung weist die Busleiterplatte eine Stiftleiste und eine Buchsenleiste auf, mittels der eine elektrische Kontaktierung und eine steckbare mechanische Verbindung zwischen den Busleiterplatten herstellbar sind. Die senkrecht zur Längsausdehnung des Busses verlaufenden Kanten der Busleiterplatte sind mit einer Stiftleiste und gegenüberliegend entsprechend mit einer Buchsenleiste versehen, so dass durch Zusammenstecken von Stift- und Buchsenleisten mehrerer Busleiterplatten eine mechanische Querverbindung für nebeneinander angeordnete Gehäuse entsteht. Die Stift- und Buchsenleisten sind mehrpolig ausgeführt, wobei die Anzahl der Kontakte variabel ist und den Erfordernissen angepasst werden kann.

Die Busleiterplatte weist Federkontakte zur elektrischen Kontaktierung von Anschlusskontakten des elektrischen Betriebsmittels auf. Das elektrische Betriebsmittel kann in oder auf das mit der Busleiterplatte verbundene Gehäuse gesetzt werden, so dass über auf der Busleiterplatte angeordnete Federkontakte eine elektrische Kontaktierung des Betriebsmittels erfolgt.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern.

Es zeigen:
- **Fig. 1a:**: eine Kontaktseite einer Busleiterplatte (2TE) mit Stiftleiste, Buchsenleiste und Federkontakten,
- **Fig. 1b:**: eine Rückseite der Busleiterplatte (2TE) mit sichtbarer Buchsenleiste,
- **Fig. 2a:**: eine Gehäusewand (2TE) mit integrierten Schnappelementen,
- **Fig. 2b:**: die Gehäusewand (2TE) mit aufgeschnappter Busleiterplatte,
- **Fig. 3a:**: die Kontaktseite einer Busleiterplatte (6TE) mit Stiftleiste, Buchsenleiste und Federkontakten,
- **Fig. 3b:**: die Gehäusewand (6TE) mit aufgeschnappter Busleiterplatte,
- **Fig. 4:**: einen Haltebügel,
- **Fig. 5a:**: die Busleiterplatte mit zwei nicht montierten Haltebügeln,
- **Fig**. **5b:**: die Busleiterplatte mit zwei montierten Haltebügeln,
- **Fig. 6a:**: die Gehäusewand eines Aufbaugehäuses mit der nicht montierten Busleiterplatte aus **Fig. 5b** und
- **Fig. 6b:**: die Gehäusewand des Aufbaugehäuses mit der montierten Busleiterplatte aus **Fig. 5b**.

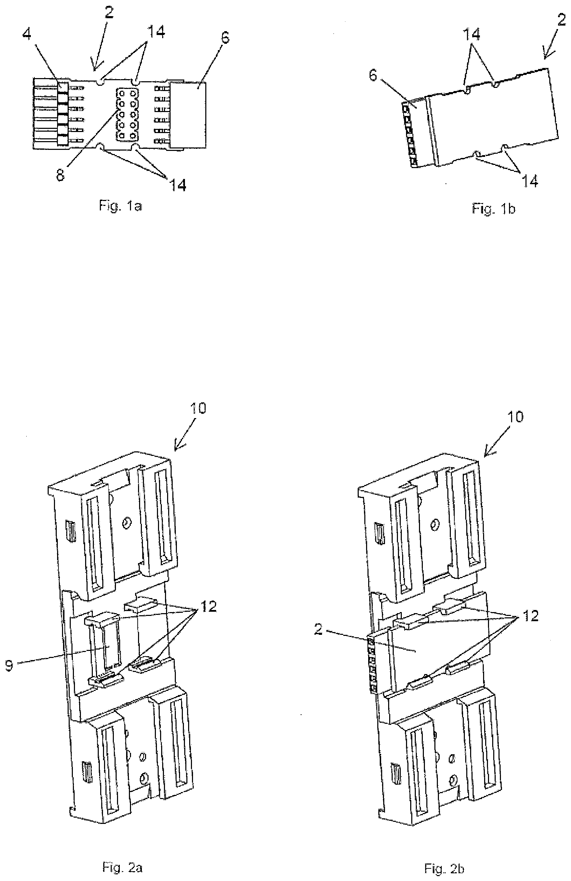

**Fig. 1a** zeigt eine Busleiterplatte 2 für die Befestigung an einer Gehäusewand 10 (**Fig. 2a**) eines 36 mm (2 Teilungseinheiten/TE) breiten DIN-Einbaugehäuses mit einen 45 mm Normausschnitt. Dargestellt ist eine Kontaktseite der Busleiterplatte 2 mit einer Stiftleiste 4, mit einer Buchsenleiste 6 und mit Federkontakten 8. Durch Zusammenstecken von Stiftleisten 4 und Buchsenleisten 6 mehrerer Busleiterplatten 2 entsteht eine elektrische und mechanische Verbindung.

In der in **Fig. 1b** gezeigten Ansicht einer der Kontaktseite gegenüberliegenden Rückseite der Busleiterplatte 2 ist der über die Busleiterplatte 2 hervorstehende Teil der Buchsenleiste 6 zu erkennen. Dieser nimmt bei dem Zusammenstecken mehrerer Busleiterplatten 2 die Stiftkontakte der Stiftleiste 4 der angrenzenden Busleiterplatte 2 auf, so dass eine durchgängige Busverbindung geschaffen werden kann.

**Fig. 2a** zeigt die Gehäusewand 10 des 2 TE-breiten DIN-Einbaugehäuses mit vier integrierten Schnappelementen 12, die als Schnapphaken 12 ausgeführt und unlösbar an die Gehäusewand 10 angeformt sind. Zur Kontaktierung weist die Gehäusewand einen zu den Federkontakten 8 korrespondierende Gehäuseöffnung 9 auf.

Wie **Fig. 2b** zeigt, hintergreifen bei aufgeschnappter Busleiterplatte 2 jeweils zwei der Schnapphaken 12 die beiden Längskanten der Busleiterplatte 2. Durch Ausnehmungen 14 (**Fig. 1a**, **1b**) in der Kontur der in Bus-Längsausdehnung verlaufenden Kanten der Busleiterplatte 2 sind die Schnapphaken 12 gegen seitliches Verschieben relativ zur Busleiterplatte 2 gesichert.

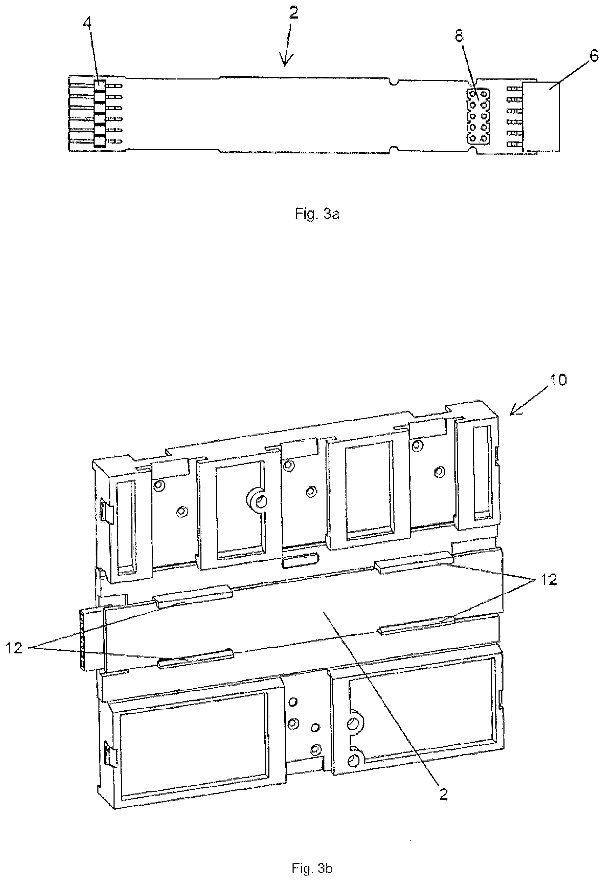

**Fig. 3a** zeigt analog zu **Fig. 1** die Kontaktseite mit Stiftleiste 4, Buchsenleiste 6 und Federkontakten 8 einer Busleiterplatte 2 für die Befestigung an einer Gehäusewand 10 (**Fig. 3b**) eines 107,5 mm (6 TE) breiten DIN-Einbaugehäuses.

Die auf die 6 TE-Gehäusewand 10 aufgeschnappte Busleiterplatte 2 ist analog zu **Fig. 2b** in **Fig. 3b** dargestellt.

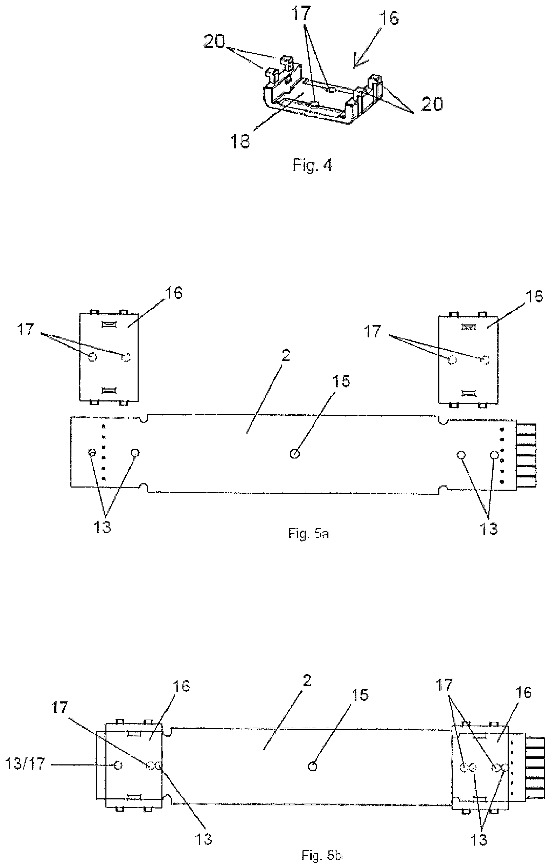

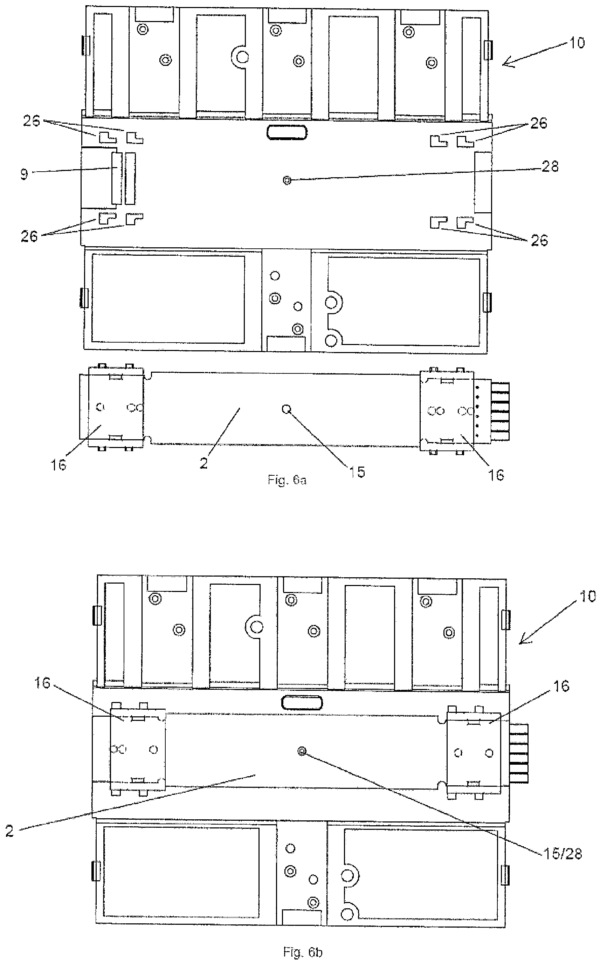

**Fig. 4** zeigt einen Haltebügel 16 zur Befestigung der Busleiterplatte 2 an der Gehäusewand 10 eines Aufbaugehäuses (**Fig. 6a**). Der Haltebügel 16 ist U-förmig ausgebildet und besteht im Wesentlichen aus einem Steg 18 als Mittelteil und zwei kürzeren Schenkelteilen. An die Schenkelteile sind jeweils zwei Haken 20 angeformt, die in entsprechende Öffnungen 26 (**Fig. 6a**) der Gehäusewand 10 (**Fig. 6a**) eingeführt und verrastet werden. Der Haltebügel 16 weist zwei kreisrunde Erhebungen 17 auf, die in entsprechende Rast-Bohrungen 13 der Busleiterplatte 2 (**Fig. 5a**) eingreifen und zum Verrasten des Haltebügels 16 dienen.

In **Fig. 5a** ist die Busleiterplatte 2 zusammen mit zwei Haltebügeln 16 in nicht montiertem Zustand dargestellt. Die Haltebügel 16 sind hier vor ihrer Montage in einer Position oberhalb der endgültigen Montageposition eingezeichnet. Die Ausnehmungen oder Sprünge in der Kontur der Längskanten der Busleiterplatte 2 - in **Fig. 5a** unterhalb der Position sichtbar, in der die noch nicht montierten Haltebügel 16 dargestellt sind - verhindern eine seitliche Verschiebung der Haltebügel 16 entlang der Busleiterplatte 2. Zur exakten Positionierung der Busleiterplatte 2 bezogen auf die Gehäusewand 10 weist die Busleiterplatte 2 eine Zentrierbohrung 15 auf, in die sich ein an die Gehäusewand 10 angeformter Zentrierstift 28 setzt (**Fig. 6a**, **6b**).

Die **Fig. 5b** zeigt die Busleiterplatte 2 mit montierten Haltebügeln 16.

In **Fig. 6a** ist beispielhaft die Gehäusewand 10 eines Aufbaugehäuses nach DIN EN 60715 mit der nicht montierten Busleiterplatte 2 aus **Fig. 5b** gezeigt. Die Gehäusewand 10 weist winkelförmige Öffnungen 26 auf, in welche die Haken 20 (**Fig. 4**) der Haltebügel 16 eingeführt und verrastet werden und somit gegen selbstständiges Lösen gesichert sind.

**Fig. 6b** zeigt die Gehäusewand 10 des Aufbaugehäuses mit der durch die Haltebügel 16 an der Gehäusewand 10 befestigten Busleiterplatte 2 aus **Fig. 5b**. Der in die Zentrierbohrung 15 der Busleiterplatte 2 eingreifende Zentrierstift 28 der Gehäusewand 10 bewirkt eine passgenaue Einführung der Federkontakte 8 in die Gehäuseöffnung 9. Daneben verhindert der Zentrierstift 28 zusätzlich zu den Ausnehmungen oder Sprüngen in der Kontur der Längskanten der Busleiterplatte 2 eine seitliche Verschiebung der Busleiterplatte 2.

## Patentansprüche

1. Busverbinder-System mit Busleiterplatten (2) zur Herstellung einer elektrischen Verbindung zwischen elektrischen Betriebsmitteln, wobei für jedes Betriebsmittel eine der Busleiterplatten (2) lösbar an einer Außenseite eines Gehäuses des jeweiligen elektrischen Betriebsmittels befestigt ist und durch Zusammenstecken der Busleiterplatten (2) eine langgestreckte Busanordnung in Form einer mechanischen Querverbindung für die seitlich nebeneinander angeordneten Gehäuse der elektrischen Betriebsmittel ausgebildet ist, und wobei die jeweilige Busleiterplatte (2) Federkontakte (8) zur elektrischen Kontaktierung von Anschlusskontakten des elektrischen Betriebsmittels aufweist, wobei die Federkontakte (8) in eine Gehäuseöffnung (9) einer Gehäusewand (10) des Gehäuses eingeführt sind, sodass eine elektrische Kontaktierung des Betriebsmittels erfolgt,
**dadurch gekennzeichnet,**
**dass** die Busleiterplatte (2) an einer Gehäusewand (10) des Gehäuses mit einem Haltebügel (16) befestigt ist, der als eigenständiges Bauelement ausgebildet ist und
Haken (20) aufweist, die in Öffnungen (26) der Gehäusewand (10) eingreifen und durch seitliches Verschieben und Verrasten gegen Lösen gesichert sind, sowie zwei kreisrunde Erhebungen (17) aufweist, die in entsprechende Rast-Bohrungen (13) der Busleiterplatte (2) eingreifen.

2. Busverbinder-System nach Anspruch 1,
**dadurch gekennzeichnet,**
**dass** die Busleiterplatte (2) eine Außenkontur mit Ausnehmungen aufweist, in die die Haltebügel (16) eingreifen.

3. Busverbinder-System mit Busleiterplatten (2) zur Herstellung einer elektrischen Verbindung zwischen elektrischen Betriebsmitteln, wobei für jedes Betriebsmittel eine der Busleiterplatten (2) lösbar an einer Außenseite eines Gehäuses des jeweiligen elektrischen Betriebsmittels befestigt ist und durch Zusammenstecken der Busleiterplatten (2) eine langgestreckte Busanordnung in Form einer mechanischen Querverbindung für die seitlich nebeneinander angeordneten Gehäuse der elektrischen Betriebsmittel ausgebildet ist, und wobei die jeweilige Busleiterplatte (2) Federkontakte (8) zur elektrischen Kontaktierung von Anschlusskontakten des elektrischen Betriebsmittels aufweist, wobei die Federkontakte (8) in eine Gehäuseöffnung (9) einer Gehäusewand (10) des Gehäuses eingeführt sind, sodass eine elektrische Kontaktierung des Betriebsmittels erfolgt ,
**dadurch gekennzeichnet,**
**dass** die Busleiterplatte (2) mit einem Schnappelement (12) an einer Gehäusewand (10) des Gehäuses befestigt ist, wobei das Schnappelement (12) als integriertes Bauelement an der Gehäusewand (10) ausgebildet ist und durch Ausnehmungen (14) in der Kontur der in Bus-Längsausdehnung verlaufenden Kanten der Busleiterplatte (2) gegen seitliches Verschieben relativ zur Busleiterplatte (2) gesichert ist.

4. Busverbinder-System nach einem der Ansprüche 1 bis 3,
**dadurch gekennzeichnet,**
**dass** die Busleiterplatte (2) eine Stiftleiste (4) und eine Buchsenleiste (6) aufweist, mittels der eine elektrische Kontaktierung und eine steckbare mechanische Verbindung zwischen den Busleiterplatten (2) herstellbar sind.

## Claims

1. A bus connector system comprising a bus circuit board (2) for producing an electrical connection between electrical equipment, one of the bus circuit boards (2) being attached in a removable manner to an exterior of a housing of the corresponding electrical equipment in the case of each piece of electrical equipment and by plugging the bus circuit boards (2) together, an elongated arrangement of buses is produced in the shape of a mechanical cross-connection for the housings of the electrical equipment, which are arranged side by side, the corresponding bus circuit board (2) having spring contacts (8) for electrically contacting terminal contacts of the electrical equipment, the spring contacts (8) being inserted into a housing opening (9) of a housing wall (10) of the housing which causes an electrical contacting of the electrical equipment,
**characterized in that**
the bus circuit board (2) is attached to a housing wall (10) of the housing using a holding bracket (16) that is realized as a separate component and has hooks (20) that engage into openings (26) of the housing wall (10) and are secured against release by being laterally displaced and locked in place as well as having two circular protrusions (17) that engage in corresponding locking bores (13) of the bus circuit board (2).

2. The bus connector system according to claim 1,
**characterized in that**
the bus circuit board (2) has an outer contour that has recesses into which the holding brackets (16) engage.

3. A bus connector system comprising a bus circuit board (2) for producing an electrical connection between electrical equipment, one of the bus circuit boards (2) being attached in a removable manner to an exterior of a housing of the corresponding electrical equipment in the case of each piece of electrical equipment and by plugging the bus circuit boards (2) together, an elongated arrangement of buses is produced in the shape of a mechanical cross-connection for the housings of the electrical equipment, which are arranged side by side, the corresponding bus circuit board (2) having spring contacts (8) for electrically contacting terminal contacts of the electrical equipment, the spring contacts (8) being inserted into a housing opening (9) of a housing wall (10) of the housing which causes an electrical contacting of the electrical equipment,
**characterized in that**
the bus circuit board (2) is attached to a housing wall (10) of the housing using a snap element (12), the snap element (12) being realized as an integrated component on the housing wall (10) and being secured against lateral displacement relative to the bus circuit board (2) via recesses (14) in the contour of the edges of the bus circuit board (2) extending along the length of the bus.

4. The bus connector system according to any one of the claims 1 to 3, **characterized in that**
the bus circuit board (2) has a male connector strip (4) and a female connector strip (6) by means of which an electrical contact and a pluggable mechanical connection can be produced between the bus circuit boards (2).

## Revendications

1. Système de connecteur bus comprenant une platine bus (2) pour produire une connexion électrique entre des pièces d'équipement électrique, une des platines bus (2) étant attachée de manière démontable à un extérieur d'un boîtier de l'équipement électrique correspondant pour chaque pièce d'équipement électrique et en rassemblant les platines bus (2), un ensemble élongé des buses étant produit en forme d'une traverse mécanique pour les boîtiers de l'équipement électrique, qui sont disposés l'un à côté de l'autre, la platine bus (2) correspondante ayant des contacts de ressort (8) pour contacter électriquement les contacts terminal de l'équipement électrique, les contacts de ressort (8) étant insérés dans une ouverture de boîtier (9) d'une paroi de boîtier (10) du boîtier qui cause un contact électrique de l'équipement électrique,
**caractérisé en ce que**
la platine bus (2) est attachée à une paroi de boîtier (10) du boîtier en utilisant un étrier de blocage (16) qui est réalisé comme composant individuel et a des crochets (20) qui s'engagent dans des ouvertures (26) de la paroi de boîtier (10) et sont sécurisés en place contre une mise hors de prise en étant déplacés et bloqués latéralement et qui a deux protrusions (17) circulaires qui s'engagent dans des trous de blocage (13) de la platine bus (2).

2. Système de connecteur bus selon la revendication 1,
**caractérisé en ce que**
la platine bus (2) a un contour extérieur qui a des évidements dans lesquels les étriers de blocage (16) s'engagent.

3. Système de connecteur bus comprenant une platine bus (2) pour produire une connexion électrique entre des pièces de l'équipement électrique, une des platines bus (2) étant attachée de manière démontable à un extérieur d'un boîtier de l'équipement électrique correspondant pour chaque pièce d'équipement électrique et en rassemblant les platines bus (2), un ensemble élongé des buses étant produit en forme d'une traverse mécanique pour les boîtiers de l'équipement électrique, qui sont disposés l'un à côté l'autre, la platine bus (2) correspondante ayant des contacts de ressort (8) pour contacter électriquement les contacts terminal de l'équipement électrique, les contacts de ressort (8) étant insérés dans une ouverture de boîtier (9) d'une paroi de boîtier (10) du boîtier qui cause un contact électrique de l'équipement électrique,
**caractérisé en ce que**
la platine bus (2) est attachée à une paroi de boîtier (10) du boîtier en utilisant un élément à cliquet (12), l'élément à cliquet (12) étant réalisé comme composant intégré sur la paroi de boîtier (10) et étant sécurisé en place contre un déplacement latéral par rapport à la platine bus (2) par des évidements (14) dans le contour des bords de la platine bus (2) s'étendant à travers la longueur du bus.

4. Système de connecteur bus selon l'une quelconque des revendication 1 à 3,
**caractérisé en ce que**
la platine bus (2) a une baguette de connexion mâle (4) et une baguette de connexion femelle (6) au moyen desquelles un contact électrique et une connexion mécanique assemblable peuvent être produits entre les platines bus (2).
